# EUROPEAN PATENT SPECIFICATION

(11) **EP 2 208 706 B1**
(45) Date of publication and mention of the grant of the patent: **21.05.2014**
(21) Application number: 08831347.3
(22) Date of filing: 16.09.2008
(51) Int. Cl.: C22C 21/00, C01B 31/02, C01B 31/04, D06M 11/83, B82Y 30/00, B82Y 40/00, C22C 47/04, C22C 49/14, B22F 1/02, C04B 35/628, D06M 101/40

(54) **METAL-COATED CARBON MATERIAL AND CARBON-METAL COMPOSITE MATERIAL USING THE SAME**
METALLBESCHICHTETES KOHLENSTOFFMATERIAL UND KOHLENSTOFF-METALL-VERBUNDWERKSTOFF DASSELBE ENTHALTEND
MATÉRIAU DE CARBONE RECOUVERT DE MÉTAL ET MATÉRIAU COMPOSITE CARBONE-MÉTAL EMPLOYANT CELUI-CI

(30) Priority: 18.09.2007 JP 2007240942
(43) Date of publication of application: 21.07.2010
(73) Proprietor: Shimane Prefectural Government, Matsue-shi Shimane 690-8501 (JP)
(72) Inventor: UENO, Toshiyuki, Matsue-shi Shimane 690-0816 (JP); YOSHINO, Katsumi, Matsue-shi Shimane 690-0816 (JP)
(74) Representative: Winter, Brandl, Fürniss, Hübner, Röss, Kaiser, Polte - Partnerschaft
(86) International application number: PCT/JP2008/066679
(87) International publication number: WO 2009/038048

(56) References cited:
- EP-A1- 1 010 770
- WO-A1-2005/059194
- WO-A1-2007/063764
- DE-A1-102005 046 710
- DE-C1- 4 204 120
- JP-A- 2000 143 247
- JP-A- 2001 131 647
- US-A- 3 473 900
- US-A- 3 622 283
- US-B1- 6 346 136
- WU JING ET AL.: 'Electrochemical performances of C/Fe nanocomposite and its use for mediator- free glucose biosensor preparation' TALANTA vol. 68, no. 1, 15 November 2005, pages 12 - 18, XP025382172

## Description

### TECHNICAL FIELD

The present invention relates to a metal-coated carbon material formed by reducing, with carbon, transition metal ions adhered on a surface of a carbon material, and relates to a carbon-metal composite material obtained by integrating the metal-coated carbon material with a matrix metal. Moreover, the present invention also relates to production methods for these materials.

### BACKGROUND ART

In order to provide various properties and achieve integration with resins or metals, surfaces of carbon materials have been modified in various ways. For example, in order to achieve integration with metals, there have been proposed surface modifications on a carbon material using Si, Ti, carbides thereof, or nitrides thereof (see Patent Citations 1 to 3). The surface modifications are conducted by CVD, PVD, or heat treatment after mixing with a target substance.

Among surface-modified carbon materials, a material subjected to a surface modification using a transition metal, particularly a transition-metal-coated carbon material that is coated with Fe, Co, or Ni, exhibits ferromagnetism. It is known that, owing to the ferromagnetism, the transition-metal-coated carbon material itself, or a composite material obtained by integration of the transition-metal-coated carbon material with a resin or metal exhibits a high electromagnetic wave shielding property (see Patent Documents 4 and 5). The magnetism of these materials varies, depending on the treatment temperature or the degree of oxidation of the transition metal element. Such electromagnetic wave shielding materials are used in a wide range of application such as prevention of malfunction of electronic devices and prevention of exposure of radio waves of a mobile phone to the human body.

As a method of coating a transition metal, a chemical plating method, a CVD method, a PVD method such as sputtering and ion plating, a vacuum deposition method, and the like are known (see Patent Citations 3 and 6 to 16 and Non-Patent Citation 1).

Meanwhile, in order to increase the mechanical strength or improve the thermal conductivity, various carbon-metal composite materials have been proposed, which are obtained by integrating carbon materials (particularly, carbon fibers) with matrix metals. Conventionally, a carbon fiber and a matrix metal have been generally integrated with each other by a method in which a molten metal is impregnated into a porous preform formed from a carbon fiber (melt impregnation method) (see Patent Citations 17 and 18 and Non-Patent Citation 1). In this method, when the temperature of a molten metal is high, the molten metal reacts with the carbon fiber to form an unfavorable product. For example, when molten aluminium reacts with a carbon fiber, deliquescent aluminium carbide Al₄C₃ is formed. To inhibit such a reaction, either of the following methods has been adopted: a coating is provided to completely cover a surface of a carbon fiber (see Patent Citation 19); or a metal is alloyed to lower the temperature of the molten metal (Patent Citation 19). However, such measures cause an increase in cost and a decrease in the thermal conductivity of the matrix metal. The thermal conductivity of an Al-SiC alloy that is widely used in the melt impregnation method is approximately 150 W/m/K, whereas that of pure aluminium has a thermal conductivity of 238 W/m/K.

Patent Citation 1: Japanese Patent Application Laid-Open No. 2006-255853
Patent Citation 2: Japanese Patent Application Laid-Open No. 2006-255852
Patent Citation 3: Japanese Patent Application Laid-Open No. H07-276034(1995)
Patent Citation 4: Japanese Patent Application Laid-Open No. 2004-14990
Patent Citation 5: Japanese Patent Application Laid-Open No. 2001-168573
Patent Citation 6: Japanese Patent Application Laid-Open No. 2006-86007
Patent Citation 7: Japanese Patent Application Laid-Open No. 2005-19058
Patent Citation 8: Japanese Patent Application Laid-Open No. 2004-354137
Patent Citation 9: Japanese Patent Application Laid-Open No. 2002-121404
Patent Citation 10: Japanese Patent Application Laid-Open No. 2001-146645
Patent Citation 11: Japanese Patent Application Laid-Open No. 2000-195998
Patent Citation 12: Japanese Patent Application Laid-Open No. 2000-191998
Patent Citation 13: Japanese Patent Application Laid-Open No. 2000-191987
Patent Citation 14: Japanese Patent Application Laid-Open No. H10-321216(1998)
Patent Citation 15: Japanese Patent Application Laid-Open No. H07-90421(1995)
Patent Citation 16: Japanese Patent Application Laid-Open No. H05-309244(1993)
Patent Citation 17: Japanese Patent Application Laid-Open No. 2000-203973
Patent Citation 18: Japanese Patent Application Laid-Open No. H09-153666(1997)
Patent Citation 19: Japanese Patent Application Laid-Open No. 2000-160309
Non-Patent Citation 1: Akira Kitahara et al., "Effect of coated metal interlayer on wettability and bonding ability between graphite/aluminum and on degradation of carbon fiber/aluminum composite," Keikinzoku, Vol. 41, No. 1, pp. 32 to 37 (1991)

### DISCLOSURE OF THE INVENTION

### TECHNICAL PROBLEM

By the conventionally adopted chemical plating method, CVD method, PVD method such as sputtering and ion plating, vacuum deposition method, or the like, a transition metal coating is produced at a low processing temperature (normal temperature to several hundred degrees celsius). This causes insufficient adhesion between a transition metal and a carbon material, and thus the transition metal coating may be exfoliated or detached in subsequent processing steps. Moreover, it has been difficult to disperse the transition metal uniformly on the surface of the carbon material. Thus, an object of the present invention is to provide a transition-metal-coated carbon material having a transition metal coating which has a high adhesion strength between the transition metal and the carbon material, and which is neither exfoliated nor detached in subsequent processing steps. Moreover, another object of the present invention is to provide a transition-metal-coated carbon material including a carbon fiber with a transition metal uniformly dispersed on its surface. Furthermore, still another object of the present invention is to provide a transition-metal-coated carbon material showing a high electromagnetic shielding effect and an excellent induction heating (IH) property.

Meanwhile, the surface of a non-surface-treated carbon material has a low affinity with a metal such as aluminium, and the low affinity is believed to make integration of the carbon material difficult. (see Non-Patent Citation 1). Moreover, the low affinity causes voids left in the composite material even if the integration is achieved. This results in problems of decreases in the mechanical strength and thermal conductivity of the obtained composite material. Thus, an object of the present invention is to provide a carbon-metal composite material having an improved affinity with a metal such as aluminium by use of a surface-treated carbon material and showing excellent mechanical strength and thermal conductivity. Furthermore, another object of the present invention is to provide a carbon-metal composite material showing a high electromagnetic shielding effect and an excellent induction heating (IH) property.

### TECHNICAL SOLUTION

A transition-metal-coated carbon material according to a first embodiment of the present invention is obtainable by: adhering a compound onto a surface of a carbon material, the compound containing transition metal ions in a first oxidation state; and reducing the transition metal ions with carbon in the carbon material by a heat treatment in any one of a vacuum and an inert atmosphere, thereby to form any one of elemental transition metal and transition metal ions in a second oxidation state, wherein the second oxidation state is a lower oxidation state than the first oxidation state, and the transition metal is selected from the group consisting of Fe, Co, Ni, Mn, Cu and Zn. The carbon material is selected from pitch-based carbon fibers having a length of 500 nm to 30 mm and polyacrylonitrile-based carbon fibers having a length of 500 nm to 30 mm.

A carbon-metal composite material according to a second embodiment of the present invention is a carbon-metal composite material obtained by integrating the transition-metal-coated carbon material according to the first embodiment with a matrix metal, wherein a content of carbon in the carbon-metal composite material is 10 to 80% by volume. Here, the matrix metal may be aluminium, copper, magnesium, and alloys based thereon. In addition, it is preferable that the integration is achieved by adopting a pulse electric current sintering method.

In the second embodiment, the carbon material is selected from pitch-based carbon fibers having a length of 500 nm to 30 mm and polyacrylonitrile-based carbon fibers having a length of 500 nm to 30 mm. Here, major axes of the carbon material are oriented at angles within ±30° with respect to a specific plane, and are randomly oriented in the specific plane. Alternatively, major axes of the carbon material are oriented at angles within ±30° with respect to a direction of a specific axis.

### ADVANTAGEOUS EFFECTS

With adopting the above-described configuration, the transition-metal-coated carbon material of the present invention has the transition metal coating which is neither exfoliated nor detached in a processing step, and in which the transition metal is uniformly dispersed. Moreover, the transition-metal-coated carbon material of the present invention shows a high electromagnetic shielding effect and an excellent IH property.

In addition, the carbon-metal composite material of the present invention has no voids left therein because the affinity between the carbon material and the metal is improved, thus showing excellent mechanical strength and thermal properties. Moreover, the carbon-metal composite material of the present invention shows a high electromagnetic shielding effect and an excellent IH property.

### BRIEF DESCRIPTION OF THE DRAWINGS

Fig. 1A is a perspective view showing a transition-metal-coated carbon material of a first embodiment of the present invention;
Fig. 1B is a cross-sectional view showing the transition-metal-coated carbon material of the first embodiment of the present invention;
Fig. 2 is a graph showing an X-ray diffraction spectrum of CCF-15.6Fe obtained in Example 1;
Fig. 3 is a view showing a scanning electron micrograph of the CCF-15.6Fe obtained in Example 1;
Fig. 4A is a view showing the distribution of C obtained by an EDX analysis on the CCF-15.6Fe obtained in Example 1;
Fig. 4B is a view showing the distribution of Fe obtained by the EDX analysis on the CCF-15.6Fe obtained in Example 1;
Fig. 5 is a view showing a scanning electron micrograph of the CCF-15. 6Fe after dry milling is performed in Example 1;
Fig. 6 is a view showing a scanning electron micrograph of CCF-1.3Fe obtained in Example 3;
Fig. 7 is a view showing a scanning electron micrograph of VGCF-1.3Fe obtained in Example 4;
Fig. 8A is a graph showing the magnetizing property of CCF-7.4Fe obtained in Example 2;
Fig. 8B is a graph showing the magnetizing property of CCF-1.8Co obtained in Example 6;
Fig. 9A is a view showing a scanning electron micrograph of acid-treated CCF-Fe obtained by acid-treating the CCF-7.4Fe of Example 2;
Fig. 9B is a view showing a scanning electron micrograph of an acid-treated CCF obtained by acid-treating a CCF;
Fig. 10A is a view showing a scanning electron micrograph of Al-(CCF-15.6Fe) obtained in Example 7;
Fig. 10B is a view showing the result of a structural analysis on the Al- (CCF-15. 6Fe) obtained in Example 7, showing a distribution state of C obtained by an EDX analysis in the same field of view as that of Fig. 10A;
Fig. 10C is a view showing the result of the structural analysis on the Al- (CCF-15. 6Fe) obtained in Example 7, showing a distribution state of Al obtained by the EDX analysis in the same field of view as that of Fig. 10A;
Fig. 10D is a view showing the result of the structural analysis on the Al-(CCF-15.6Fe) obtained in Example 7, showing a distribution state of Fe obtained by the EDX analysis in the same field of view as that of Fig. 10A;
Fig. 11 is a view showing a scanning electron micrograph of a cross section of the Al-(CCF-15.6Fe) obtained in Example 7;
Fig. 12 is a view showing a scanning electron micrograph of a cross section of a Ni-coated CCF obtained in Comparative Example 1; and
Fig. 13 is a graph showing the magnetizing properties of Al-(CCF-7.4Fe) obtained in Example 8, Al-(VGCF-2.2Fe) obtained in Example 12, and Al-CCF obtained in Comparative Example 2.

### EXPLANATION OF REFERENCE

1 carbon material
2 elemental transition metal or transition metal ions in second oxidation state
10 small pore

### BEST MODES FOR CARRYING OUT THE INVENTION

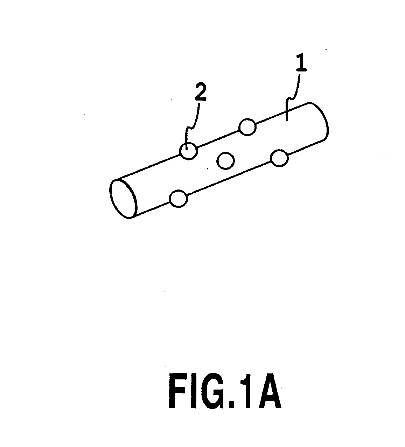

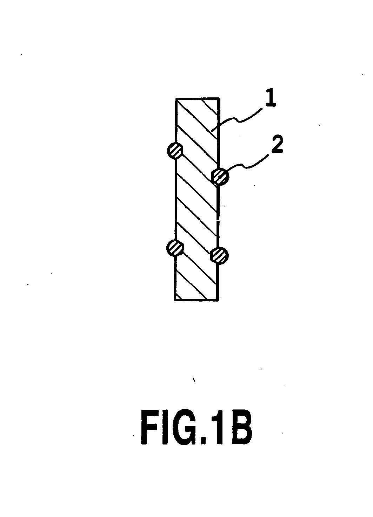

Fig. 1A and Fig. 1B show a transition-metal-coated carbon material of a first embodiment of the present invention. Fig. 1A is a perspective view of the transition-metal-coated carbon material of this embodiment. Fig. 1B is a cross-sectional view of the transition-metal-coated carbon material of this embodiment. The transition-metal-coated carbon material of this embodiment is obtained by the following processing steps. Specifically, a compound containing transition metal ions in a first oxidation state is adhered onto a surface of a carbon material. A heat treatment is performed in a reducing atmosphere, and the transition metal ions are reduced with carbon (C) in the carbon material, thereby to form elemental transition metal or transition metal ions in a second oxidation state. The second oxidation state is a lower oxidation state than the first oxidation state. The transition metal is selected from the group consisting of Fe, Co, Ni, Mn, Cu and Zn.

The carbon material in the present invention desirably has a tensile modulus of 600 GPa or more. Meanwhile, when more emphasis is placed on the thermal conductivity, desirably used is a carbon material having a tensile modulus of 800 GPa or more and a thermal conductivity of 500 W/m/K, and preferably 500 to 1500 W/m/K.

Moreover, the carbon material used in the present invention desirably has a form with a major axis and a minor axis. In the present invention, a preferable form of the carbon material is fiber. In the present invention, from the point of improvement in the orientation of the carbon material, the carbon material preferably has an aspect ratio (major axis/minor axis ratio) of 10 to 5000, and preferably 100 to 5000. Preferably, the carbon material of the present invention has a dimension of 500 nm to 30 mm in a direction of the major axis.

The carbon material which can be used in the present invention includes pitch-based carbon fibers, polyacrylonitrile (PAN)-based carbon fibers, carbon nanofibers, multi-walled carbon nanotubes (MWCNTs, including vapor grown carbon fibers (VGCFs)), single-walled carbon nanotubes (SWCNTs), carbon nanoyarns obtained by twisting any of the above-described carbon nanotubes, and carbon nanosheets. Pitch-based carbon fibers having a length of 500 nm to 30 mm, PAN-based carbon fibers having a length of 500 nm to 30 mm, carbon nanofibers having a length of 50 nm to 30 mm, MWCNTs having a length of 50 nm to 30 mm, SWCNTs having a length of 50 nm to 30 mm, or carbon nanoyarns obtained by twisting the carbon nanotubes so as to have a length of 500 nm to 30 mm are used as a preferable carbon material in the present invention.

The transition metal ions in the first oxidation state in the present invention include Fe³⁺, Co²⁺, and the like. The compound containing the transition metal ions in the first oxidation state which is used for adhesion to the carbon material include oxides such as Fe₂O₃, Fe (III) -EDTA salts (here, EDTA represents ethylenediaminetetraacetic acid), or salts such as Fe(NO₃)₃.

When a poorly soluble salt or oxide, such as Fe₂O₃, is used, the compound containing the transition metal ions in the first oxidation state may be adhered to the carbon material by a physical adhesion method. This method can be carried out by mixing, for example, a fine powder of such an oxide or salt, the carbon material, and optionally a dispersion medium together by a physical mixing method such as a ball mill. The fine powder of the oxide or salt used in this step desirably has an average particle diameter of 0.5 µm or smaller. The useful dispersion medium includes water, ethanol and isopropanol, but is not limited to these. When the dispersion medium is used, the dispersion medium to be mixed has a volume of at least 20 times, and preferably at least 30 times, as large as a total volume of the carbon material and the compound containing the transition metal ions in the first oxidation state. After mixing, the dispersion medium is evaporated, to obtain the carbon material to which the compound containing the transition metal ions in the first oxidation state is adhered.

Alternatively, when a water-soluble oxide or salt such as a Fe(III)-EDTA salt is used, adhesion of the compound containing the transition metal ions in the first oxidation state to the carbon material may be conducted by adhering an aqueous solution of such an oxide or salt to the carbon material by a technique such as immersion or application, and then evaporating water used as the solvent.

Next, a heat treatment is performed in a vacuum or inert atmosphere on the carbon material to which the compound containing the transition metal ions in the first oxidation state is adhered. Accordingly, the transition metal ions are reduced with C in the carbon material. Thereby, the elemental transition metal or the transition metal ions in the second oxidation state are formed. The inert atmosphere that can be employed includes an inert gas such as nitrogen or argon. The vacuum in this step means an atmosphere with a pressure of preferably 50 Pa or less. When any of these conditions is adopted, the carbon material to which the compound containing the transition metal ions in the first oxidation state is adhered is heated at 1000°C or higher, preferably 1000 to 1500°C, and more preferably 1100°C to 1500°C. Accordingly, the transition metal ions in the first oxidation state are reduced with C in the carbon material, thereby to form the elemental transition metal (that is, in a zero-valent oxidation state) or the transition metal ions in the second oxidation state. Here, the second oxidation state is a lower oxidation state than the first oxidation state. The transition metal ions in the second oxidation state in the present invention include Fe²⁺, Mn²⁺, Cu⁺, and the like.

As shown in Fig. 1B, when the transition metal ions in the first oxidation state are thermally reduced, C in the carbon material is consumed, and small pores are formed in a surface of a carbon material 1. Then, a thermally reduced elemental transition metal or transition metal ions in the second oxidation state 2 are formed in the form of particulates adhered in the small pores. The adhesion of the particulates of the elemental transition metal or the transition metal ions in the second oxidation state 2 into the small pores allows the coating to obtain a high bonding strength, in comparison with a transition metal coating formed by a plating method, a PVD method, a CVD method, or the like.

When Fe, Co, Ni or Mn is used as the transition metal, the transition-metal-coated carbon material of this embodiment shows ferromagnetism. The transition-metal-coated carbon material obtained by using such a transition metal has a high electromagnetic shielding effect and an IH property owing to the ferromagnetism. The "IH property" in the present invention means such a property that, when applying a magnetic field whose direction is reversed at a high frequency, eddy currents are generated within a material, thereby to heat the material. Such a transition-metal-coated carbon material is capable of orienting in a certain direction by application of a magnetic field when integrated with a metal or resin.

The transition-metal-coated carbon material of this embodiment can be used for integration with an organic resin such as a thermoplastic resin, a thermosetting resin or a photo-curing resin, in addition to integration with a matrix metal as will be described below.

A carbon-metal composite material according to a second embodiment of the present invention is obtained by integrating the transition-metal-coated carbon material of the first embodiment with a matrix metal (metallic matrix), wherein the content of C in the carbon-metal composite material is 10 to 80% by volume.

The useful matrix metal in this embodiment includes aluminum (Al), magnesium (Mg), copper (Cu), and alloys based on these metals. When used for integration with a transition-metal-coated carbon material, it is desirable to use a matrix metal in the form of a particulate having an average particle diameter of 200 nm to 500 µm, and preferably 500 nm to 50 µm.

The transition-metal-coated carbon material and the matrix metal can be integrated with each other by forming a slurry containing the transition-metal-coated carbon material, the particulates of the matrix metal and a dispersion medium, removing the dispersion medium from the slurry to form a sintering precursor, and then sintering the sintering precursor.

The useful dispersion medium for forming the slurry includes alcohols such as ethanol and propanol, and alkanes such as n-hexane. Such a dispersion medium is preferable in light of inhibiting oxidation of the matrix metal, particularly Al, Mg, and alloys based on the metals. When Cu and alloys based on Cu are used as the matrix metal, the oxidation of the matrix metal does not have to be considered, and accordingly water can be used as the dispersion medium.

When the slurry is formed, the dispersion medium to be used has a volume of one to ten times, and desirably two to four times, as large as the volume of solid content (that is, a total volume of the transition-metal-coated carbon material and the particulates of the matrix metal). Use of the dispersion medium having such a volume ratio makes it possible to obtain a slurry having such a viscosity as to allow the transition-metal-coated carbon material to rotate freely.

The slurry can be formed by dispersing a mixture of the transition-metal-coated carbon material, the matrix metal particulates and the dispersion medium by any physical mixing method known in the art such as a ball mill. Even when such a physical mixing method is adopted, particulates of the transition metal in the transition-metal-coated carbon material of the first embodiment of the present invention are neither exfoliated (separated) nor detached from the surface of the carbon material. This is because the particulates of the transition metal are formed in the small pores that are formed in the surface of the carbon material.

Next, the dispersion medium is removed from the obtained slurry to form the sintering precursor. The dispersion medium can be removed by evaporating the dispersion medium with heating, or the dispersion medium can be removed by use of a porous material such as gypsum (slip casting).

When using a transition-metal-coated carbon material having an aspect ratio of 10 to 5000 and coated with Fe, Co, Ni or Mn, the transition-metal-coated carbon material can be oriented in one direction by applying a magnetic field during the formation of the sintering precursor. The magnetic field to be applied is desirably a parallel magnetic field having a magnetic flux density of 0.01 to 1 T.

Then, the obtained sintering precursor is sintered by adopting a pressure sintering method such as a hot isostatic pressing sintering method (HIP), a uniaxial pressure sintering method (hot pressing), and a pulse electric current sintering method. The pulse electric current sintering method is a method comprising the steps of: providing a graphite mold having a through hole ; placing the sintering precursor in the through hole; sandwiching sintering precursor with an upper punch and a lower punch; sintering the precursor by passing a pulse current through the upper and lower punches while applying a pressure to the upper and lower punches for uniaxial pressing. In this embodiment, the pulse electric current sintering method is desirably adopted. When Al, Mg, or an alloy based on the metals is used as the matrix metal, oxide films formed on the particulate surfaces of these metals are broken down by application of a mechanical pressure, and the surface of a metal is brought into contact with that of another metal, thereby enabling it to obtain a more closely packed sintered compact. The sintering is desirably performed in an inert atmosphere such as nitrogen or an inert gas, or in a vacuum with a pressure of 100 Pa or less.

When a transition-metal-coated carbon material having an aspect ratio of 10 to 5000 is used, orientation of the transition-metal-coated carbon material parallel to a pressing surface (that is, a plane perpendicular to a pressurizing direction) can be achieved by sintering by means of the pulse electric current sintering method, or the hot pressing involving the uniaxial pressing. The transition-metal-coated carbon material rotates in the sintering precursor, causing the major axis of the transition-metal-coated carbon material and the pressing surface to form an angle within ±30°. Here, the transition-metal-coated carbon material is randomly oriented in the pressing surface. In other words, projection lines of the major axes of the transition-metal-coated carbon material onto the pressing surface are randomly directed.

Suppose a case where a transition-metal-coated carbon material having an aspect ratio of 10 to 5000 and coated with Fe, Co, Ni or Mn is used and a sintering precursor with the transition-metal-coated carbon material oriented by application of a magnetic field is used. In this case, the sintering by adopting the pulse electric current sintering method or the hot pressing involving the uniaxial pressing makes it possible to obtain a carbon-metal composite material in which the transition-metal-coated carbon material is oriented in one direction. In the carbon-metal composite material, the angle between the major axis of the transition-metal-coated carbon material and a particular axis thereof (that is, an axis along which a magnetic field is applied) is made within ±30°. Here, it is important to select the orientation direction so that an orientation axis (that is, the axis along which the magnetic field is applied) of the transition-metal-coated carbon material is perpendicular to a pressing axis because of the following reason. The sintering proceeds with the matrix metal flowing into voids of the porous sintering precursor. However, at the sintering temperature (650°C or lower, desirably 600°C) of Al and Mg and the sintering temperature (1000°C or lower, desirably 900°C) of Cu, neither diffusion nor plastic deformation of the carbon material occurs. Thus, if the pressing axis coincides with the orientation axis, breakage or disorder in orientation of the transition-metal-coated carbon material may occur.

When it is desirable to obtain a quasi-isotropic composite material by randomly orienting the transition-metal-coated carbon material, an isotropic pressure sintering method such as HIP can be adopted.

Alternatively, the carbon-metal composite material of this embodiment may be formed by adopting a melt impregnation method. In this case, a transition-metal-coated carbon material, a binder (such as an organic resin) and a dispersion medium are mixed together, and the dispersion medium is removed from the mixture to form a porous preform. For the removal of the dispersion medium, any of a heating evaporation method and a slip casting method may be adopted. Next, a melt of a matrix metal is poured onto the preform, followed by heating and pressurizing to impregnate the melt into voids in the preform. Thus, the composite material is obtained.

Suppose a case where, in a melt impregnation method using a transition-metal-coated carbon material having an aspect ratio of 10 to 5000 and coated with Fe, Co, Ni or Mn, a composite material including the transition-metal-coated carbon material oriented along a specific axis is formed. In this case, a magnetic field is applied during the formation of the preform. By the application of the magnetic field, the preform in which the transition-metal-coated carbon material is oriented in the direction of the magnetic field is obtained. While the preform is uniaxially pressed, the melt of the matrix metal is impregnated thereinto. Thereby, a composite material is obtained while the binder is carbonized. Also in this case also, it is desirable to suppress the breakage of the transition-metal-coated carbon material and the disorder in orientation thereof by setting the orientation axis of the transition-metal-coated carbon material perpendicular to the pressing axis during the impregnation.

The carbon-metal composite material of this embodiment has a dense (closely packed) structure with a density approaching to the ideal density. This is because the affinity between the carbon material and the matrix metal is improved owing to the presence of the transition metal, with which the carbon material is coated, forming no voids inside the composite material. Moreover, the carbon-metal composite material of this embodiment shows a high mechanical strength, since the transition metal coating is present in the small pores of the carbon material surface, and a strong bond is formed between the transition metal coating and the matrix metal.

The carbon-metal composite material of this embodiment shows a high thermal conductivity of 85 W/m/K or more, and desirably 150 W/m/K or more, attributed to the carbon material. Having a high thermal conductivity particularly in the orientation surface or orientation axis of the carbon material, the carbon-metal composite material of this embodiment is useful as a heat dissipation member capable of selecting the direction. Moreover, the carbon-metal composite material of this embodiment has a low thermal expansion coefficient of 15 ppm/K or lower, and desirably 10 ppm/K or lower, particularly in the orientation surface or orientation axis of the carbon material. This property is useful particularly when the carbon-metal composite material of this embodiment is used as a member which requires the dimensional stability.

Furthermore, the carbon-metal composite material produced by using the transition-metal-coated carbon material coated with Fe, Co, Ni or Mn has ferromagnetism attributable to the transition-metal-coated carbon material, and accordingly shows excellent electromagnetic shielding property and IH heating property. Thus, such a carbon-metal composite material is useful as an electromagnetic shielding member and an IH heating member. Additionally, when a heat source is made of a ferromagnet, the carbon-metal composite material having ferromagnetism is contacted more intimately to the heat source by attraction with the magnetic force, and accordingly the efficiency as the heat dissipation member is improved.

### Examples

### (Example 1)

Into a polypropylene pot having a capacity of 500 mL were added 50 g of a pitch-based carbon fiber (chopped carbon fiber, hereinafter CCF) having an average diameter of 10 µm, a length of 1 mm, and a tensile modulus of 900 GPa or more; 10 g of a Fe₂O₃ powder (20% by weight based on the weight of CCF) having a particle diameter of 0.5 µm; and 50 g of water (approximately twice the total volume of solid contents). Furthermore, 300 g of stainless balls having a diameter of 10 mm were added into the pot, and the pot was then placed in a horizontal ball mill. The CCF and the Fe₂O₃ powder were mixed by operating the ball mill at a revolution of 120 rpm for one hour. After the mixing was completed, the water was evaporated using a constant-temperature dryer set at 70°C. Thus, a CCF/Fe₂O₃ mixture was obtained.

The obtained CCF/Fe₂O₃ mixture was transferred to a 500-mL alumina crucible, which was then placed in a vacuum electric furnace. While the pressure inside the furnace was maintained at 30 Pa, Fe₂O₃ was reduced by heating up to 1100°C with taking a period of 3 hours. Continuously, the temperature was lowered to obtain a Fe-adhered CCF. The reduction of Fe₂O₃ follows a reaction formula below:

Fe₂O₃ + 3C → 2Fe + 3CO ↑ (1).

By considering the amount of Fe formed in this reaction and the amount of carbon consumed, the Fe-adhered CCF that is the final product contained 15.6% by weight of Fe. Hereinafter, this Fe-adhered CCF is referred to as "CCF-15.6Fe".

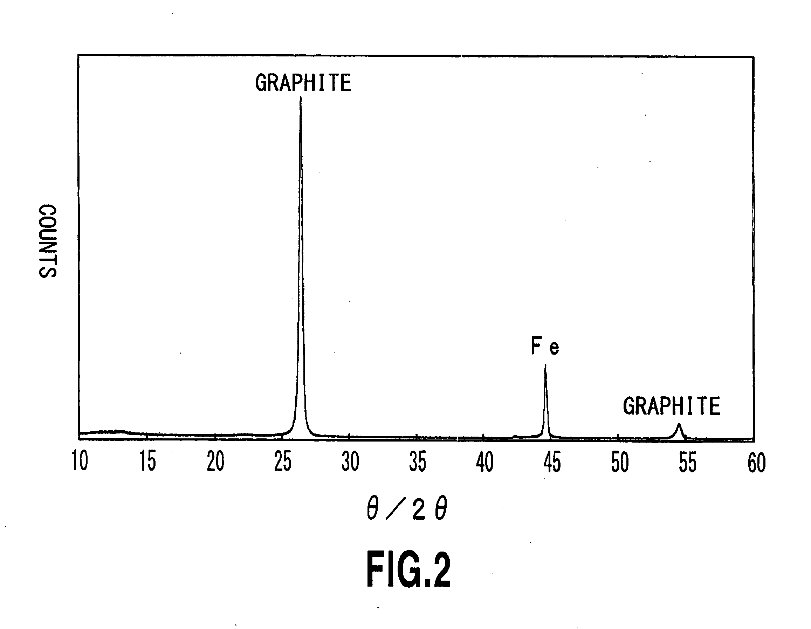

Fig. 2 shows an X-ray diffraction spectrum of the obtained CCF-15.6Fe. In Fig. 2, no peak derived from iron oxide was observed. Thus, it was revealed that the used Fe₂O₃ was completely reduced and that the CCF-15.6Fe was formed of only Fe and C.

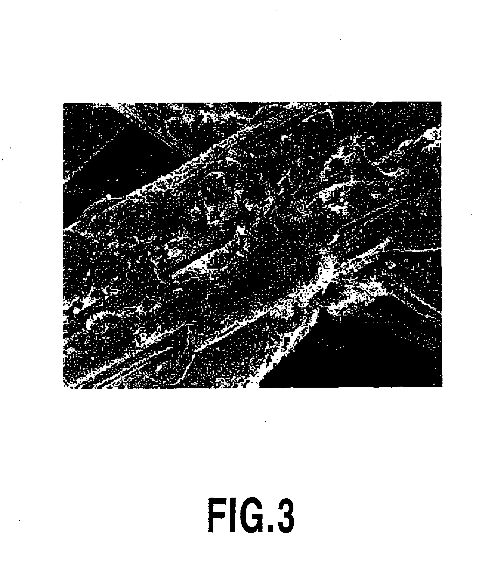

Fig. 3 shows a scanning electron micrograph of the obtained CCF-15.6Fe. As apparent from Fig. 3, a small pore where C was consumed by the reduction reaction was formed in the surface of the carbon fiber, and a coating that appears to be Fe was present inside and around the small pore.

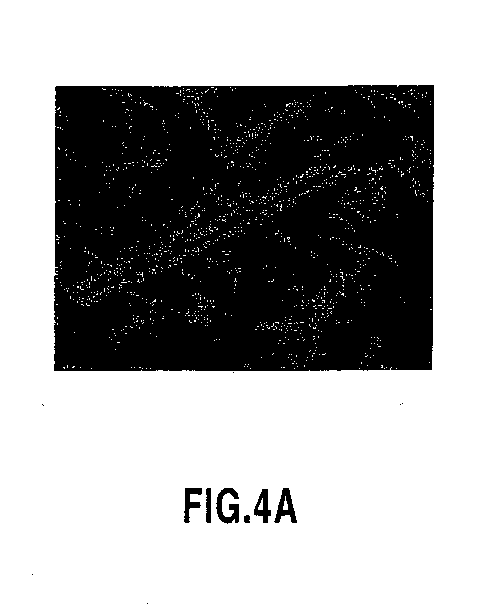

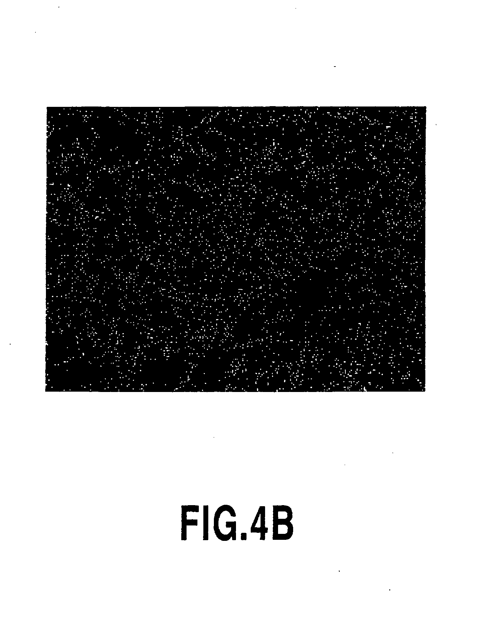

Moreover, Fig. 4A and Fig. 4B show the observation results, by an energy dispersive X-ray spectroscopy (EDX) analysis, of distributions of Fe and C in the obtained CCF-15.6Fe. Fig. 4A is a view showing the distribution of C. Fig. 4B is a view showing the distribution of Fe. As apparent from Fig. 4A and Fig. 4B, Fe was uniformly distributed on the CCF.

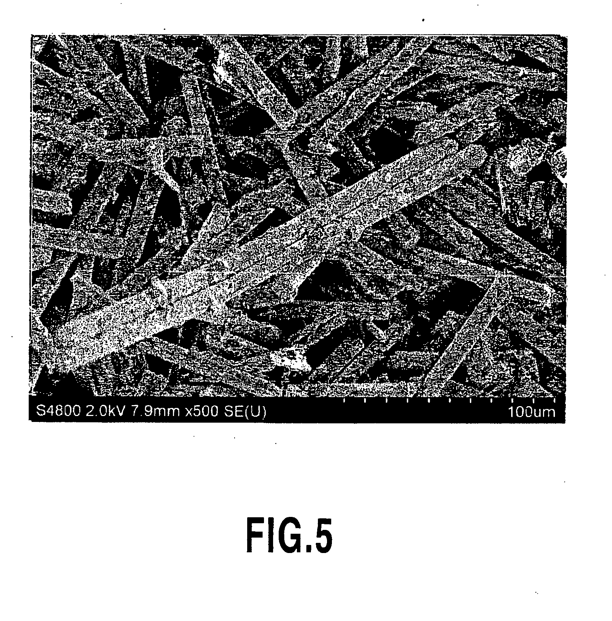

Furthermore, 20 g of the CCF-15.6Fe together with 100 g of stainless balls having a diameter of 10 mm was added into a 500-mL polypropylene pot. The pot was placed in a horizontal ball mill, and dry milling was performed thereon at a revolution of 120 rpm for one hour. Fig. 5 shows a SEM micrograph of the CCF-15.6Fe after the dry milling. As apparent from Fig. 5, no detachment of the coating formed of Fe from the CCF was observed. Thus, it was revealed that a strong bond was formed between the CCF and Fe.

### (Example 2)

The procedure in Example 1 was repeated except that the amount of the Fe₂O₃ powder was changed to 3.5 g. Thereby, a Fe-adhered CCF was prepared. The obtained Fe-adhered CCF contained 7.4% by weight of Fe. Hereinafter, this Fe-adhered CCF is referred to as "CCF-7.4Fe".

### (Example 3)

Into 100 mL of an aqueous solution containing 2% by weight of a Fe(III)-EDTA salt, 20 g of a CCF having a length of 1 mm and a tensile modulus of 900 GPa or more was immersed. This mixture was heated to 70°C for approximately 24 hours to adhere the Fe(III)-EDTA salt to the CCF while evaporating water. The salt-adhered CCF thus obtained was transferred to a 500-mL alumina crucible. Thereafter, the same treatment procedure as in Example 1 was performed to obtain a Fe-adhered CCF.

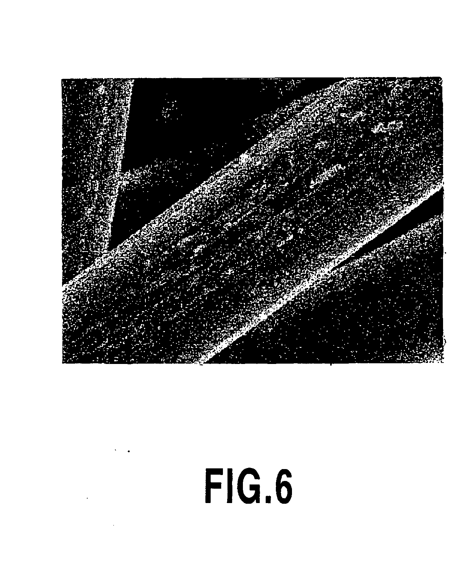

Fig. 6 shows a scanning electron micrograph of the Fe-adhered CCF. As apparent from the comparison between Fig. 6 and Fig. 3, it was found out that, in comparison with Example 1 where Fe₂O₃ was used as a raw material, the surface of the CCF was coated with finer Fe in this Example. If the Fe(III)-EDTA salt as the Fe source were completely reduced to the metallic (elemental) Fe, the content of Fe in the Fe-adhered CCF would be 1.3% by weight. Hereinafter, this Fe-adhered CCF is referred to as "CCF-1.3Fe".

### (Example 4)

Into 100 mL of an aqueous solution containing 2% by weight of the Fe(III)-EDTA salt, 20 g of a vapor grown carbon fiber (VGCF) having an average diameter of 200 nm and a length of 1 µm or longer was immersed. This mixture was heated to 70°C for approximately 24 hours to adhere the Fe(III)-EDTA salt to the VGCF while evaporating water. The salt-adhered VGCF thus obtained was transferred to a 500-mL alumina crucible. Thereafter, the same treatment procedure as in Example 1 was performed to obtain a Fe-adhered VGCF.

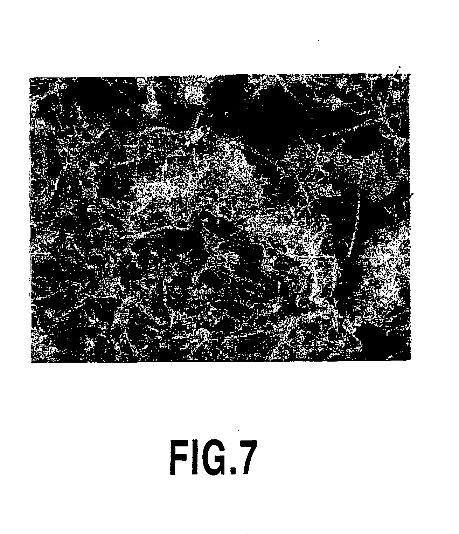

Fig. 7 shows a scanning electron micrograph of the Fe-adhered VGCF. From Fig. 7, it was found out that the surface of the VGCF was coated with fine Fe. If the Fe(III)-EDTA salt as the Fe source were completely reduced to the metallic Fe, the content of Fe in the Fe-adhered VGCF would be 1.3% by weight. Hereinafter, this Fe-adhered VGCF is referred to as "VGCF-1.3Fe".

### (Example 5)

The procedure in Example 4 was repeated except that 12 g of the VGCF was used. Thereby, a Fe-adhered VGCF was obtained. If the Fe(III)-EDTA salt as the Fe source were completely reduced to the metallic Fe, the content of Fe in the Fe-adhered VGCF would be 2.2% by weight. Hereinafter, this Fe-adhered VGCF is referred to as "VGCF-2.2Fe".

### (Example 6)

Into 100 mL of an aqueous solution containing 2% by weight of Co(NO₃)_{2˙}6H₂O_{,} 20 g of a CCF having a length of 1 mm and a tensile modulus of 900 GPa or more was immersed. This mixture was heated to 70°C for approximately 24 hours to adhere Co (NO₃)₂ to the CCF while evaporating water. The salt-adhered CCF thus obtained was transferred to a 500-mL alumina crucible. Thereafter, the same treatment procedure as in Example 1 was performed to obtain a Co-adhered CCF. If Co(NO₃)₂·6H₂O as the Co source were completely reduced to the metallic Co, the content of Co in the Co-adhered CCF would be 1.8% by weight. Hereinafter, this Co-adhered CCF is referred to as "CCF-1. 8Co".

### (Evaluation)

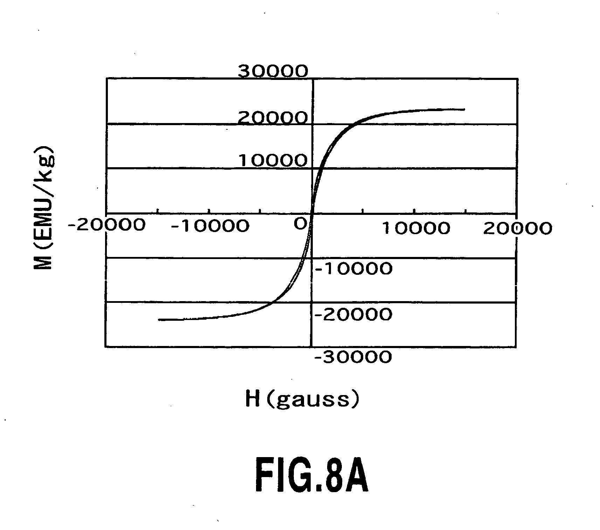

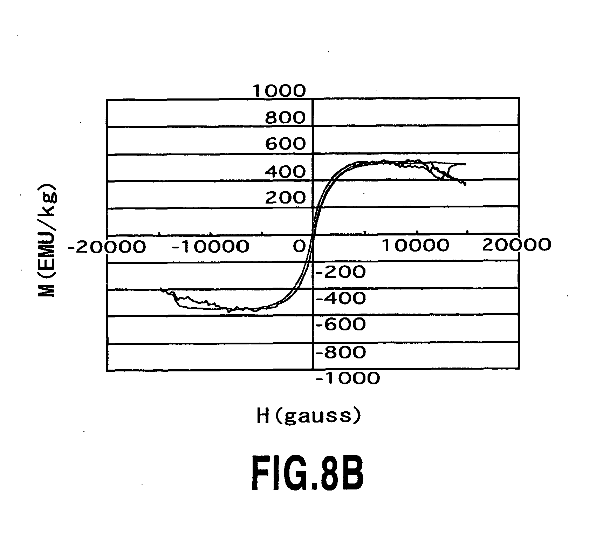

Fig. 8A and Fig. 8B show the magnetizing properties of the CCF-7.4Fe obtained in Example 2 and the CCF-1.8Co obtained in Example 6. Fig. 8A shows the magnetizing property of the CCF-7.4Fe. Fig. 8B shows the magnetizing property of the CCF-1.8Co. As apparent from Fig. 8A, the CCF-7.4Fe showed ferromagnetism and had a high magnetic susceptibility. Moreover, as found out from Fig. 8B, the CCF-1.8Co also showed ferromagnetism, although the CCF-1.8Co fell short of the CCF-7.4Fe in terms of the magnetic susceptibility. The difference between the CCF-7.4Fe and the CCF-1.8Co in magnetic susceptibility is attributed to the difference in coating amount.

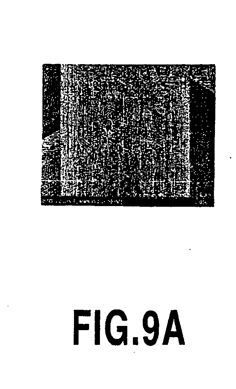

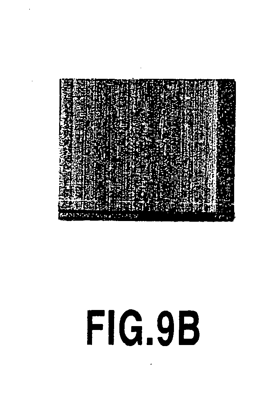

Into 1 M hydrochloric acid, 0. 5 g of the CCF-7.4Fe obtained in Example 2 was immersed for 2 hours to remove Fe, followed by neutralization, washing and drying to prepare acid-treated CCF-Fe. A CCF used as a raw material in Example 2 was treated in a similar manner to prepare an acid-treated CCF. Fig. 9A and Fig. 9B are views for explaining changes in the surface of the carbon material caused by the adhered transition metal. Fig. 9A shows a scanning electron micrograph of the acid-treated CCF-Fe. Fig. 9B shows a scanning electron micrograph of the acid-treated CCF. In the surface of the acid-treated CCF shown in Fig. 9B, only linear asperities presumably formed during the spinning were observed. In contrast, small pores having a dimension of approximately 1 µm by 1 µm were observed in the CCF surface of the acid-treated CCF-Fe shown in Fig. 9A. It is believed that the small pores were formed due to consumption of C during the reduction of Fe₂O₃.

### (Example 7)

The CCF-15.6Fe prepared in Example 1 was mixed with an Al powder having an average particle diameter of 5 µm. The content of the CCF-15.6Fe in the mixture was 60% by volume. Into a 500-mL polypropylene pot were added 30 parts by weight of the obtained mixture, 70 parts by weight of ethanol, and 100 parts by weight of stainless balls having a diameter of 10 mm. The polypropylene pot was placed in a horizontal ball mill, which was then operated at 120 rpm for 2 hours to obtain a slurry.

The ethanol was evaporated from the obtained slurry to obtain a CCF-15.6Fe/Al mixture. A graphite mold for pulse electric current sintering was used, the mold having a cylindrical through hole with a diameter of 20 mm. A lower punch was inserted into the through hole. Next, the through hole was filled with the CCF-15.6Fe/Al mixture. Then, an upper punch was inserted into the through hole.

The mold for pulse electric current sintering was placed in a device for pulse electric current sintering. The pressure inside the device was lowered to 10 Pa or less. While applying a pressure of 50 MPa to the upper and lower punches, a current having a current density of 750 A/cm², a pulse width of approximately 0.5 ms and a pulse frequency of 375 Hz was passed through the CCF-15.6Fe/Al mixture for sintering. The CCF-15.6Fe was integrated with Al. Thus, a carbon-metal composite material was obtained. Hereinafter, the obtained composite material is referred to as "Al-(CCF-15.6Fe)". The maximum voltage was 6 V, and the maximum current was approximately 3000 A, in this example.

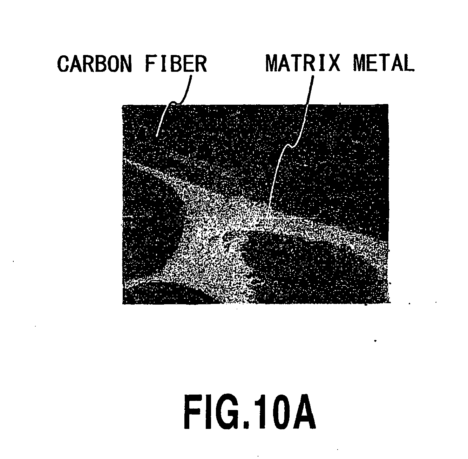

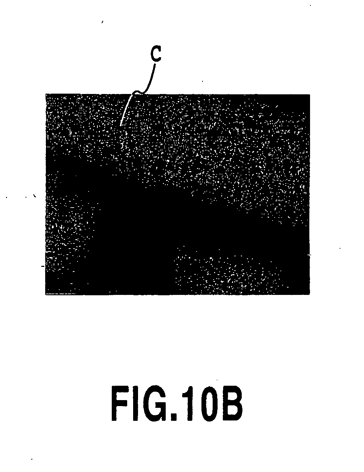

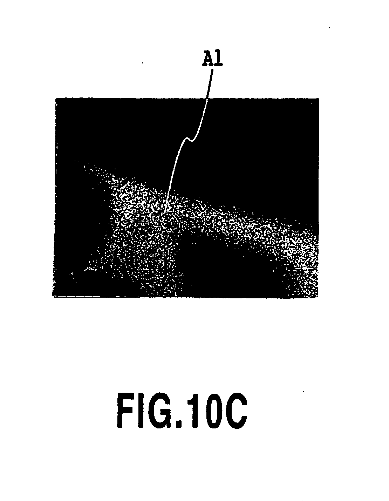

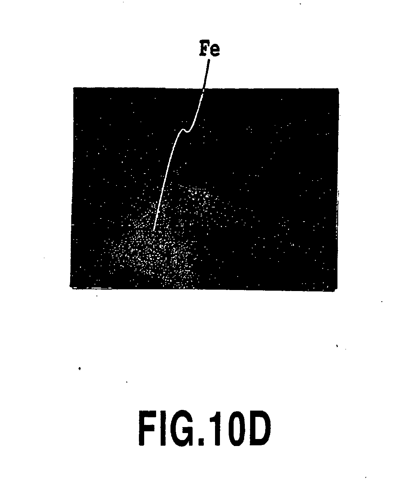

Fig. 10A to Fig. 10D show the results of a structural analysis on the Al-(CCF-15.6Fe) obtained in this Example. Fig. 10A is a scanning electron microscope (SEM) micrograph showing a micro-structure of the Al- (CCF-15.6Fe). Fig. 10B to Fig. 10D are views showing the respective distribution states of C, Al and Fe according to an EDX analysis. From the results of this analysis, it was revealed that Fe was localized in the vicinity of the carbon fiber. From this result, it was revealed that, when a transition-metal-coated carbon material is used to produce a composite material with another metal by a sintering method, the transition metal can maintain the localized state in the vicinity of the carbon material without being uniformly solid-solubilized.

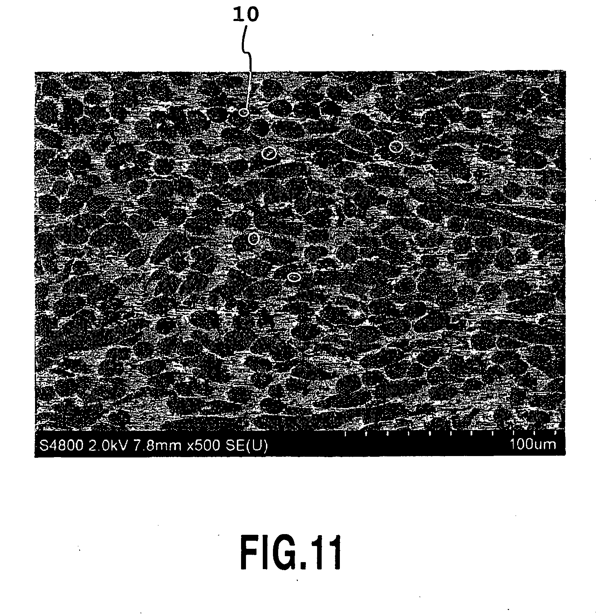

Moreover, Fig. 11 shows a SEM micrograph of a cross section, perpendicular to the orientation direction of the CCF, of the Al- (CCF-15. 6Fe) obtained in this Example. As apparent from Fig. 11, small pores 10 having a width of approximately 1 µm to 2 µm and a depth of approximately 1 µm were observed in the interface between the metal and the CCF.

### (Comparative Example 1)

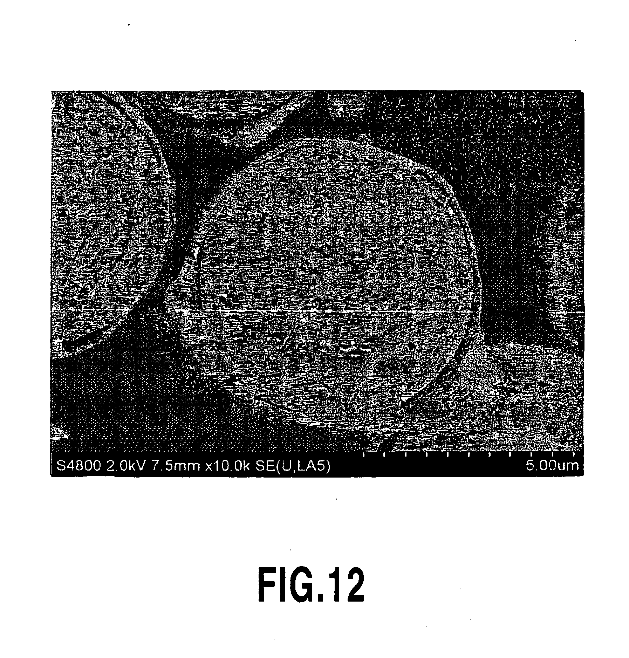

The surface of the CCF used in Example 1 was coated with Ni by electroless plating. Fig. 12 shows a SEM micrograph of a cross section of the obtained Ni-coated CCF. As apparent from Fig. 12, no small pore was observed in the surface of the CCF, since the carbon material itself was not used as a reducing agent in this Comparative Example. Moreover, with regard to Ni-coated CCFs prepared by means of a CVD method, a sputtering method, an ion plating method, or a vacuum deposition method, instead of electroless plating, no small pore was observed on the surface of the CCF.

### (Example 8)

The procedure in Example 7 was repeated except that the CCF-7.4Fe obtained in Example 2 was used instead of the CCF-15.6Fe prepared in Example 1. Thereby, a carbon-metal composite material was obtained. Hereinafter, the obtained composite material is referred to as "Al-(CCF-7.4Fe)".

### (Example 9)

The procedure in Example 7 was repeated except that the CCF-1.3Fe obtained in Example 3 was used instead of the CCF-15.6Fe prepared in Example 1. Thereby, a carbon-metal composite material was obtained. Hereinafter, the obtained composite material is referred to as "Al-(CCF-1.3Fe)".

Using the Al-(CCF-1.3Fe) obtained in this Example, a test piece having a width of approximately 2 mm, a thickness of approximately 1.5 mm, and a length of approximately 20 mm was prepared. The test piece thus prepared was evaluated by three-point bending with fulcrums being apart from each other by 16 mm. The bending strength was 107.2 MPa.

### (Example 10)

The procedure in Example 7 was repeated except that the CCF-1.8Co obtained in Example 6 was used instead of the CCF-15.6Fe prepared in Example 1. Thereby, a carbon-metal composite material was obtained. Hereinafter, the obtained composite material is referred to as "Al-(CCF-1.8Co)".

### (Example 11)

The VGCF-1.3Fe prepared in Example 4 was mixed with an Al powder having an average particle diameter of 5 µm. The content of the VGCF-1.3Fe in the mixture was 30% by volume. Thereafter, the procedure in Example 7 was repeated, and thereby a carbon-metal composite material was obtained. Hereinafter, the obtained composite material is referred to as "Al-(VGCF-1.3Fe)".

### (Example 12)

The VGCF-2.2Fe prepared in Example 5 was mixed with an Al powder having an average particle diameter of 5 µm. The content of the VGCF-2.2Fe in the mixture was 30% by volume. Thereafter, the procedure in Example 7 was repeated, and thereby a carbon-metal composite material was obtained. Hereinafter, the obtained composite material is referred to as "Al-(VGCF-2.2Fe)".

### (Example 13)

The procedure in Example 7 was repeated except that the CCF-7.4Fe obtained in Example 2 was used instead of the CCF-15.6Fe prepared in Example 1 and that a Cu powder having an average particle diameter of 5 µm was used instead of the Al powder. Thereby, a carbon-metal composite material was obtained. Hereinafter, the obtained composite material is referred to as "Cu-(CCF-7.4Fe)".

### (Example 14)

Using the same procedure as that adopted in Example 7, the CCF-15.6Fe was mixed with an Al powder having an average particle diameter of 5 µm to form a slurry.

A mold was prepared in which gypsum was placed into a through hole of an acrylic cylindrical container, the through hole being in a square form with one side of 20 mm. To this mold, a magnetic field having a magnetic flux density of 0.5 T in a horizontal direction (that is, a direction along one pair of opposite sides of the square) was applied. In this state, the slurry was poured into the acrylic cylindrical container from the top, and ethanol was removed with the gypsum, while the CCF-15.6Fe was oriented in the direction of the magnetic field. Thereby, a sintering precursor was obtained.

The sintering precursor was taken out from the acrylic cylindrical container in such a manner as not to alter the external appearance thereof. A graphite mold for pulse electric current sintering was prepared, the mold having a through hole in a square form with one side of 20 mm. A lower punch was inserted into the through hole. The sintering precursor was placed on the lower punch. Then, an upper punch was placed on the sintering precursor.

The mold for pulse electric current sintering was placed in a device for pulse electric current sintering, and sintering was performed by the same procedure as in Example 7. Thus, a carbon-metal composite material was obtained. Hereinafter, the obtained composite material is referred to as "oriented Al-(CCF-15.6Fe)".

### (Comparative Example 2)

The procedure in Example 7 was repeated except that the CCF used in Example 1 was used instead of the CCF-15.6Fe prepared in Example 1. Thereby, a carbon-metal composite material was obtained. Hereinafter, the obtained composite material is referred to as "Al-CCF".

Using the Al-CCF obtained in this Example, a test piece having a width of approximately 2 mm, a thickness of approximately 1.5 mm, and a length of approximately 20 mm was prepared. The test piece thus prepared was evaluated by three-point bending with fulcrums being apart from each other by 16 mm. The bending strength was 96.1 MPa.

From the comparison with the evaluation result of Example 9, it was found out that the Al- (CCF-1. 3Fe) with Fe adhered on the surface of the CCF showed a higher bending strength by approximately 10% than the Al-CCF with no Fe adhered thereon. It is believed that this effect is attributed to (a) improvement in the density of the composite material, and (b) improvement in the adhesion between carbon and aluminium due to anchoring effect by the small pores and the formation of an interface layer generated from Fe.

### (Comparative Example 3)

The procedure in Example 7 was repeated except that VGCF used in Example 4 was used instead of the VGCF-1.3Fe prepared in Example 4. Thereby, a carbon-metal composite material was obtained. Hereinafter, the obtained composite material is referred to as "Al-VGCF".

### (Comparative Example 4)

The procedure in Example 7 was repeated except that a CCF used in Example 1 was used instead of the CCF-15.6Fe prepared in Example 1 and that a Cu powder having an average particle diameter of 5 µm was used instead of the Al powder. Thereby, a carbon-metal composite material was obtained. Hereinafter, the obtained composite material is referred to as "Cu-CCF".

### (Evaluation)

The composite materials obtained in Examples 7 and 9 to 14 and Comparative Examples 2 to 4 were evaluated on the relative densities, as well as the thermal conductivity and the thermal expansion coefficient in each direction, and the results were shown in Table 1. The "relative density" in the present invention is a value representing, by percentage, a ratio of a measured bulk density to the ideal density calculated from the density and the blending ratio of each component of the composite material, under the assumption that no void is present. The relative density of 100% means that no void is present at all in the composite material. Moreover, a direction "Z" means a direction of uniaxial pressing during pulse electric current sintering. In Examples 7 and 9 to 13 and Comparative Examples 2 to 4, directions "X" and "Y" mean two directions which are perpendicular to the direction "Z". In Example 14, the direction "X" means a direction in which a magnetic field is applied, and the direction "Y" means a direction which is perpendicular to the directions "X" and "Z".

**[Table 1]**

| Table 1: Evaluation on composite materials | | | | | |
|---|---|---|---|---|---|
| Example | Composite material (volume ratio relative to carbon material) | Relative density (%) | Direction | Thermal conductivity (W/m/K) | Thermal expansion coefficient (ppm/K) |
| Example 7 | Al-(CCF-15.6Fe) | 99.5 | X | 210 | 7 |
| | (60%) | | Y | 210 | 7 |
| | | | Z | 40 | 21 |
| Example 9 | Al-(CCF-1.3Fe) | 99.3 | X | 220 | 6 |
| | (60%) | | Y | 220 | 6 |
| | | | Z | 35 | 22 |
| Example 10 | Al-(CCF-1.8Co) | 100.0 | X | 210 | 8 |
| | (60%) | | Y | 210 | 8 |
| | | | Z | 40 | 23 |
| Example 14 | Oriented Al-(CCF-15. 6Fe) | 99.5 | X | 350 | 3 |
| | (60%) | | Y | 120 | 10 |
| | | | Z | 40 | 21 |
| Comparative Example 2 | Al-CCF | 92 | X | 150 | 8 |
| | (60%) | | Y | 150 | 8 |
| | | | Z | 20 | 23 |
| Example 11 | Al-(VGCF1.3Fe) | 99.8 | X | 85 | 14 |
| | (30%) | | Y | 85 | 14 |
| | | | Z | 40 | 18 |
| Comparative Example 3 | Al-VGCF | 93 | X | 80 | 14 |
| | (30%) | | Y | 80 | 14 |
| | | | Z | 15 | 18 |
| Example 13 | Cu-(CCF-7.4Fe) | 99.0 | X | 210 | 1.6 |
| | (60%) | | Y | 210 | 1.6 |
| | | | Z | 61 | 23 |
| Comparative Example 4 | Cu-CCF | 99.1 | X | 270 | 3.5 |
| | (60%) | | Y | 270 | 3.5 |
| | | | Z | 70 | 30 |

As apparent from the comparison among Examples 7, 9, 10 and Comparative Example 2, and the comparison between Example 11 and Comparative Example 3, it was found out that the coating of the surface of the carbon material (CCF and VGCF) with Fe increased the relative density of the composite material to almost 100%, and accordingly a composite material without voids was obtained. This indicates that a low affinity between C and Al was improved owing to the presence of Fe. Moreover, together with the improvement in the relative density, the improvement in the thermal conductivity was observed in a direction along the pressing surface (that is, in the directions "X" and "Y").

In Example 14 where the magnetic field was applied during the slip casting, it was revealed that extremely high thermal conductivity and low thermal expansion coefficient were shown in the direction in which the magnetic field was applied (that is, in the direction "X"), in comparison with the composite materials of Example 7 and Comparative Example 2. This is presumably because the CCF-15. 6Fe was oriented in the direction "X" by the application of the magnetic field.

Additionally, from the comparison between Example 13 and Comparative Example 4 in each of which Cu was used as the matrix metal, it was revealed that the coating with Fe had an effect of lowering the thermal expansion coefficient. This effect is attributed to the improvement in the adhesion between the carbon material and Cu.

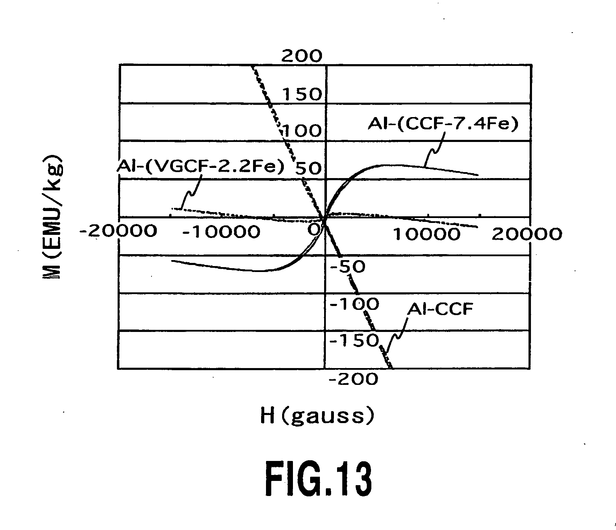

The magnetizing properties of the Al-(CCF-7.4Fe) obtained in Example 8, the Al-(VGCF-2.2Fe) obtained in Example 12, and the Al-CCF obtained in Comparative Example 2 were measured with a VSM. Fig. 13 shows the results. As apparent from the results in Fig. 13, the Al-CCF without a transition metal coating showed diamagnetism derived from the CCF, whereas the Al- (CCF-7. 4Fe) and the Al-(VGCF-2.2Fe) with the transition metal coatings showed ferromagnetism.

## Claims

1. A transition-metal-coated carbon material obtainable by:
adhering a compound onto a surface of a carbon material, the compound containing transition metal ions in a first oxidation state; and reducing the transition metal ions with carbon in the carbon material by a heat treatment in any one of a vacuum and
an inert atmosphere, thereby to form any one of elemental transition metal and transition metal ions in a second oxidation state, wherein
the second oxidation state is a lower oxidation state than the first oxidation state,
the transition metal is selected from the group consisting of Fe, Co, Ni, Mn, Cu and Zn, and
the carbon material is selected from the group consisting of pitch-based carbon fibers having a length of 500 nm to 30 mm, and polyacrylonitrile-based carbon fibers having a length of 500 nm to 30 mm.

2. A carbon-metal composite material obtained by integrating the transition-metal-coated carbon material according to claim 1 with a matrix metal, wherein a content of carbon in the carbon-metal composite material is 10 to 80% by volume.

3. The carbon-metal composite material according to claim 2, wherein the matrix metal is selected from the group consisting of aluminium, copper, magnesium, and alloys based on the metals.

4. The carbon-metal composite material according to claim 2, wherein the integration is achieved by a pulse electric current sintering method.

5. The carbon-metal composite material according to claim 2, wherein major axes of the carbon material are oriented at angles within ±30° with respect to a specific plane, and are randomly oriented in the specific plane.

6. The carbon-metal composite material according to claim 2, wherein major axes of the carbon material are oriented at angles within ±30° with respect to a direction of a specific axis.

## Patentansprüche

1. Mit Übergangsmetall beschichtetes Kohlematerial, erhältlich durch: Binden einer Verbindung auf einer Oberfläche eines Kohlematerials, wobei die Verbindung Übergangsmetallionen einer ersten Oxidationsstufe enthält; und Reduzieren der Übergangsmetallionen mit Kohlenstoff in dem Kohlematerial durch eine Wärmebehandlung unter Vakuum oder einer Inertgasatmosphäre zur Bildung von einem von elementarem Übergangsmetall und Übergangsmetallionen in einer zweiten Oxidationsstufe, wobei
die zweite Oxidationsstufe eine niedrigere Oxidationsstufe ist als die erste Oxidationsstufe,
das Übergangsmetall ausgewählt ist aus der Gruppe bestehend aus Fe, Co, Ni, Mn, Cu und Zn, und
das Kohlematerial ausgewählt ist aus der Gruppe bestehend aus Kohlenstofffasern auf Pechbasis mit einer Länge von 500 nm bis 30 mm und Kohlenstofffasern auf Basis von Polyacrylnitril mit einer Länge von 500 nm bis 30 mm.

2. Kohlenstoff-Metall-Verbundwerkstoff, erhalten durch Integrieren des mit Übergangsmetall beschichteten Kohlematerials nach Anspruch 1 in ein Matrixmetall, wobei der Kohlenstoffgehalt in dem Kohlenstoff-Metall-Verbundwerkstoff 10 bis 80 Vol.-% beträgt.

3. Kohlenstoff-Metall-Verbundwerkstoff nach Anspruch 2, wobei das Matrixmetall ausgewählt ist aus der Gruppe bestehend aus Aluminium, Kupfer, Magnesium und Legierungen auf Basis dieser Metalle.

4. Kohlenstoff-Metall-Verbundwerkstoff nach Anspruch 2, wobei die Integration durch ein Sinterverfahren mit gepulstem elektrischem Strom erfolgt.

5. Kohlenstoff-Metall-Verbundwerkstoff nach Anspruch 2, wobei die Hauptachsen des Kohlematerials in Winkeln von innerhalb ±30° bezüglich einer spezifischen Ebene orientiert sind und in der spezifischen Ebene zufällig orientiert sind.

6. Kohlenstoff-Metall-Verbundwerkstoff nach Anspruch 2, wobei die Hauptachsen des Kohlematerials in Winkeln von innerhalb ±30° bezüglich einer Richtung einer spezifischen Achse orientiert sind.

## Revendications

1. Un matériau carboné revêtu d'un métal de transition susceptible d'être produit par : adhésion d'un composé sur une surface d'un matériau carboné, le composé contenant des ions de métaux de transition dans un premier état d'oxydation, et par réduction des ions de métaux de transition par le carbone contenu dans le matériau carboné par un traitement thermique soit sous vide soit dans une atmosphère inerte, de manière à former l'un quelconque des ions de métaux de transition et de métaux de transition sous forme élémentaire dans un second état d'oxydation, dans lequel
- le second état d'oxydation est un état d'oxydation inférieur à celui du premier état d'oxydation, et
- le métal de transition est choisi dans le groupe constitué par Fe, Co, Ni, Mn, Cu et Zn, et
- le matériau carboné est choisi dans le groupe consistant en fibres de carbone à base d'asphalte présentant une longueur de 500 nm à 30 mm, et des fibres de carbone à base de polyacrylonitrile présentant une longueur de 500 nm à 50 mm.

2. Un matériau composite carbone-métal obtenu par intégration du matériau carboné revêtu de métal de transition selon la revendication 1, avec un métal de matrice, dans lequel la teneur en carbone dans le matériau composite carbone-métal est de 10 à 80% en volume.

3. Le matériau composite carbone-métal selon la revendication 2, dans lequel le métal de matrice est choisi dans le groupe constitué par l'aluminium, le cuivre, le magnésium et les alliages à base de ces métaux.

4. Le matériau composite carbone-métal selon la revendication 2, dans lequel l'intégration est réalisée par un procédé de frittage par courant électrique pulsé.

5. Le matériau composite carbone-métal selon la revendication 2, dans lequel des axes majeurs du matériau carboné sont orientés selon des angles de ±30° par rapport à un plan spécifique, et sont orientés de façon aléatoire dans le plan spécifique.

6. Le matériau composite carbone-métal selon la revendication 2, dans lequel des axes majeurs du matériau carboné sont orientés selon des angles de ±30° par rapport à une direction d'un axe spécifique.
